# EUROPEAN PATENT APPLICATION

(11) **EP 0 538 004 A2**
(43) Date of publication of application: **21.04.1993**
(21) Application number: 92309355.3
(22) Date of filing: 14.10.1992
(51) Int. Cl.: H01L 29/784, H01L 29/08, H01L 29/72, H01L 29/06

(54) **Field effect semiconductor device and method of fabricating same**

(30) Priority: 14.10.1991 JP 264651/91
(71) Applicant: MITSUBISHI DENKI KABUSHIKI KAISHA, Tokyo 100 (JP)
(72) Inventor: Hatade, Kazunari, c/o Mitsubishi Denki K.K., Nishi-ku, Fukuoka-shi, Fukuoka (JP); Yamaguchi, Hiroshi c/o Mitsubishi Denki K.K., Nishi-ku, Fukuoka-shi, Fukuoka (JP)
(74) Representative: Hackett, Sean James

(57) **Abstract**

There is provided an area (5R), in which an n⁺ source region (5) is exposed in ring form, inside a channel formation region (6). A p-type semiconductor region (3) and the n⁺ source region (5) are alternately exposed to form a checkered pattern inside the area (5R). A source electrode contacts the n⁺ source region (5) and p-type semiconductor region (3) in an area (AR). Although a hole current flows into p-type semiconductor regions (3b) through the area (5R), its route is short so that a voltage drop is small therein. An npn parasitic transistor formed with the p-type semiconductor region (3), n⁺ source region (5) and an n drain region lying thereunder is not turned on. The feild effect semiconductor device is prevented from being broken down by the npn parasitic transistor.

## Description

### BACKGROUND OF THE INVENTION

### Field of the Invention

The present invention relates to a field effect semiconductor device and a method of fabricating the same. More particularly, the invention relates to an improvement for preventing the breakdown of the field effect semiconductor device through a parasitic transistor.

### Description of the Background Art

### < Structure of Conventional Device >

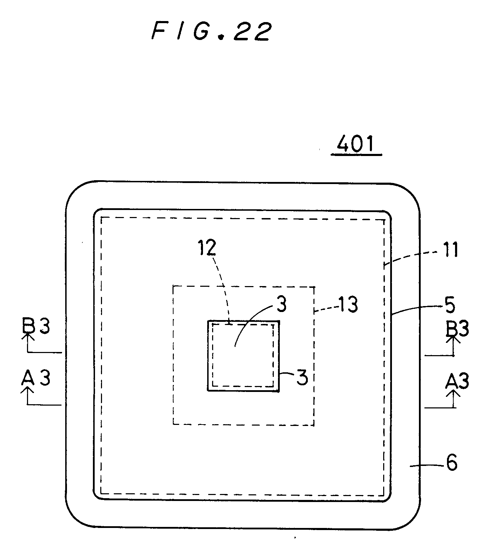

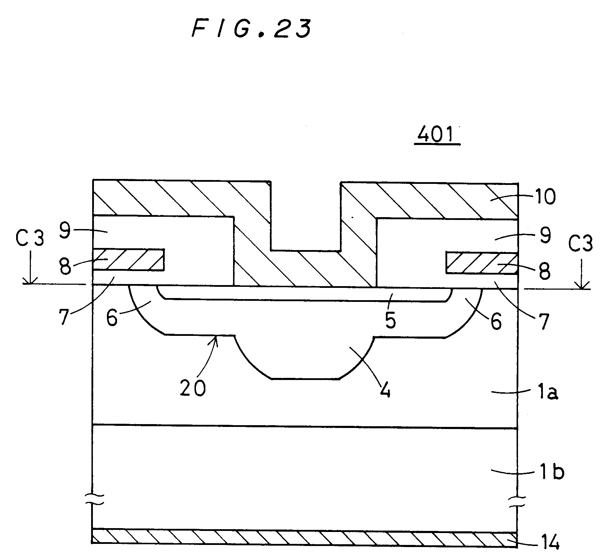

Fig. 22 is a plan view of one cell of a conventional N-channel power MOS field effect transistor (referred to as a power MOSFET hereinafter) 401. Figs. 22 and 23 are cross-sectional views taken along the lines A3 - A3 and B3 - B3 of Fig. 22, respectively. Fig. 22 corresponds to a plan view as viewed along the line C3 - C3 of Fig. 23.

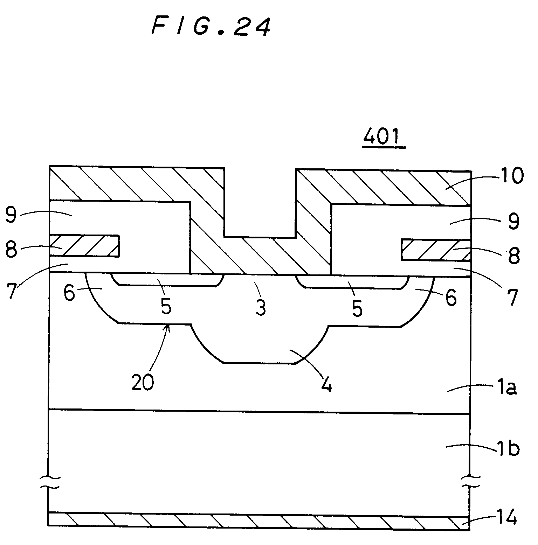

With reference to Fig. 24, the power MOSFET 401 includes an n⁻ drain region 1a and an n⁺ drain region 1b. A p-type region 20 is selectively formed in an upper surface portion of the n⁻ drain region 1a. The p-type region 20 includes a combination of a p⁺ semiconductor region 4 and a p-type semiconductor region 3. The peripheral portion of the p-type semiconductor region 3 is a rectangular, ringlike channel formation region 6, as shown in Fig. 22.

An n⁺ source region 5 is selectively formed in an upper surface portion of the p-type region 20. As shown in Fig. 22, the n⁺ source region 5 is of rectangular, ringlike configuration, and the p-type semiconductor region 3 is exposed in the center of the n⁺ source region 5.

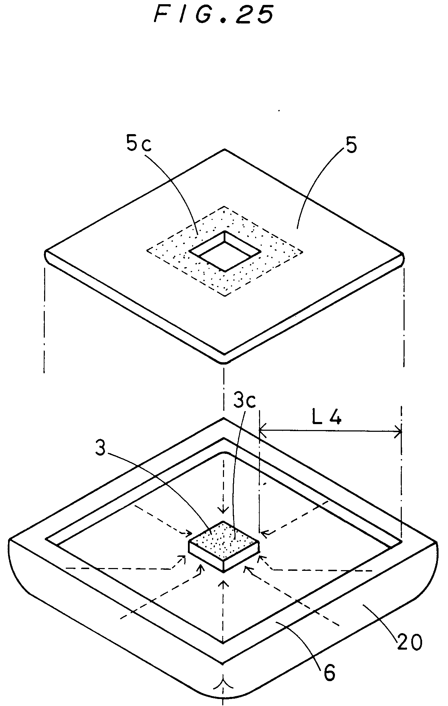

There is shown in Fig. 25 such geometric relation between the p-type region 20 and n⁺ source region 5. In Fig. 25, the p-type region 20 and n⁺ source region 5 are shown vertically spaced apart from each other in simplified configurations for the purpose of simplification.

Referring again to Fig. 24, a gate oxide film 7 is selectively formed on the upper major surface of a semiconductor body including the semiconductor regions. A gate electrode 8 is provided on the gate oxide film 7. A layer insulating film 9 lies on the gate electrode 8.

There is shown in Fig. 22 a mask pattern 11 used for the formation of the whole p-type semiconductor region 3 with broken lines. In Fig. 22 are also shown mask patterns 12 and 13 used for the formation of the n⁺ source region 5 and for the patterning of the insulating films 7, 9, respectively.

A source electrode 10 is formed on the top surface of the power MOSFET 401. Part of the source electrode 10 contacts the p-type semiconductor region 3 and n⁺ source region 5 in a window of the insulating films 7 and 9. This causes the p-type semiconductor region 3 and n⁺ source region 5 to short-circuit each other, and a source potential is applied to the p-type semiconductor region 3 and n⁺ source region 5 from the source electrode 10. Areas 3c and 5c shaded with dots in Fig. 25 are parts of the regions 3 and 5 which are brought into contact with the source electrode 10.

A drain electrode 14 in contact with the n⁺ drain region 1b is formed on the bottom surface of the power MOSFET 401.

### < Operations and Characteristics of Conventional Device >

Channels are formed in the channel formation region 6 in the power MOSFET 401 when a drain voltage is applied across the drain and source electrodes 14 and 10 and a gate voltage is applied across the gate and source electrodes 8 and 10. A drain current flows across the drain and source electrodes 14 and 10 through the channels. The magnitude of the drain current is controlled by variations in magnitude of the gate voltage.

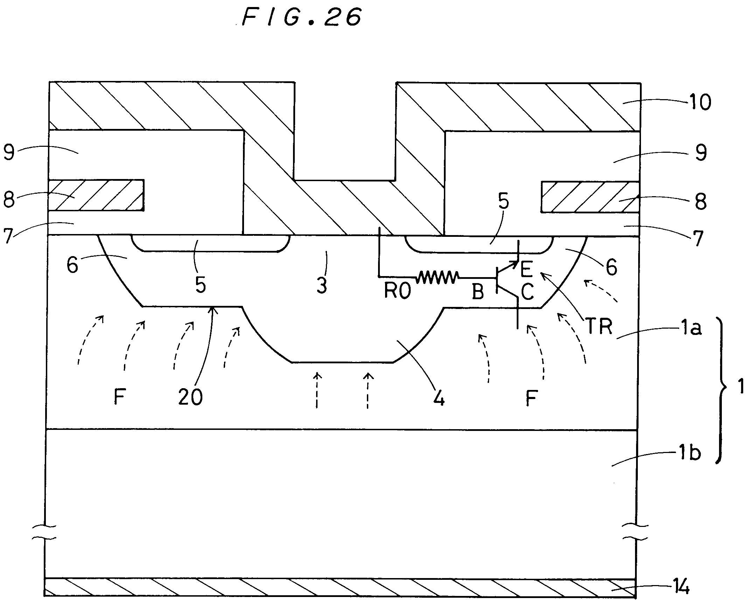

The power MOSFET 401, unfortunately, includes an npn parasitic bipolar transistor TR composed of the p-type semiconductor region 3 serving as a base B, the n⁻ drain region 1a serving as a collector C, and the n⁺ source region 5 serving as an emitter E, as shown in Fig. 26. When the power MOSFET 401 used for, e.g., a drive circuit of a motor is switched from the ON-state to the OFF-state, a counter electromotive force on the motor side is transitionally applied across the drain and source electrodes 14 and 10 so that a parasitic diode composed of the p-type semiconductor region 3 and n⁻ drain region 1a conducts. Thereafter, when a power supply voltage is applied across the drain and source electrodes 14 and 10 of the power MOSFET 401 in the OFF-state, residual carriers in the n⁻ and n⁺ drain regions 1a and 1b travel toward the source electrode 10 as indicated by the broken arrows F of Fig. 26.

Since the p-type semiconductor region 3 in this portion has a relatively high resistivity and is laterally long, a base resistance R₀ of the parasitic transistor TR is correspondingly large. In particular, since a diagonal length L4 of the cell is considerably large as shown in Fig. 25, the base resistance R₀ is particularly large for the carriers travelling through the diagonal portion.

Such a large base resistance R₀ causes a large voltage drop. The emitter E and base B are forward-biased when an emitter-base voltage V_{BE} exceeds 0.6 V. In this state, when the power supply voltage in the OFF-state is applied between the collector C and emitter E, the parasitic transistor conducts, resulting in the breakdown of the power MOSFET 401.

### SUMMARY OF THE INVENTION

According to the present invention, a field effect semiconductor device comprises: (a) a semiconductor body including: (a-1) a first semiconductor region of a first conductivity type exposed on an upper major surface of the semiconductor body; (a-2) a second semiconductor region of a second conductivity type selectively formed in an upper surface portion of the first semiconductor region and selectively exposed on the upper major surface of the semiconductor body; and (a-3) a third semiconductor region of the first conductivity type selectively formed in an upper surface portion of the second semiconductor region and exposed in a ringlike exposed area inside a peripheral portion of the exposed surface of the second semiconductor region, the third semiconductor region being exposed alternately with the second semiconductor region inside the ringlike exposed area to form an alternately exposed pattern on the upper major surface of the semiconductor body; (b) an insulating layer selectively formed on the upper major surface of the semiconductor body and having a window on a first area partially covering the alternately exposed pattern; (c) a control electrode layer buried in the insulating layer and opposed to the peripheral portion of the exposed surface of the second semiconductor region; (d) a first major electrode layer formed in the window and contacting the alternately exposed pattern in the first area; and (e) a second major electrode layer formed on a lower major surface of the semiconductor body.

Preferably, the second semiconductor region includes: (a-2-1) a first portion selectively exposed in a center portion of the first area; and (a-2-2) a plurality of second portions selectively exposed across an edge of the first area.

The present invention is also directed to a method of fabricating a field effect semiconductor device. According to the present invention, the method comprises the steps of: (a) providing a semiconductor body including a first semiconductor region of a first conductivity type, the first semiconductor region being exposed on an upper major surface of the semiconductor body; (b) selectively introducing impurities of a second conductivity type into the upper major surface of the semiconductor body to selectively form a second semiconductor region of the second conductivity type in an upper surface portion of the first semiconductor region, the second semiconductor region being selectively exposed on the upper major surface of the semiconductor body; (c) forming an oxide film on the upper major surface of the semiconductor body; (d) forming on the oxide film a control electrode layer having a first window on an area having a part of the oxide film which is opposed to the second semiconductor region; (e) selectively further introducing impurities of the second conductivity type into the upper major surface of the semiconductor body through the first window; (f) selectively diffusing the impurities of the second conductivity type introduced in the step (e) into the first semiconductor region to expand the second semiconductor region up to a part of the semiconductor body which lies under the control electrode layer; (g) selectively removing a part of the oxide film which lies under the first window to provide a combination of a first insulating film and an insulating pattern, the first insulating film lying under the control electrode layer, the insulating pattern selectively lying in the first window; (h) selectively introducing impurities of the first conductivity type into the exposed surface of the second semiconductor region except an peripheral portion thereof while using the insulating pattern as a mask, to selectively form a third semiconductor region of the first conductivity type in an upper surface portion of the second semiconductor region, the third semiconductor region being exposed alternately with the second semiconductor region inside the area to form an alternately exposed pattern on the upper major surface of the semiconductor body; (i) removing the insulating pattern; (j) forming a second insulating film covering side and upper surfaces of the control electrode layer and having a second window opposed to a part of the alternately exposed pattern; (k) forming a first major electrode layer in the second window; and (l) forming a second major electrode layer on a lower major surface of the semiconductor body.

In the field effect semiconductor device of the present invention, the exposed portions of the second and third semiconductor regions are alternately arranged on the upper major surface of the semiconductor body to form the alternately exposed pattern. Part of the alternately exposed pattern contacts the first major electrode layer. Thus the exposed portions of the second semiconductor region in plurality are in contact with the first major electrode layer.

When carriers travel from the first semiconductor region through the second semiconductor region to the first major electrode layer, the carriers reach the first major electrode layer by way of the nearest portion of the exposed portions of the second semiconductor region. The carriers travel a relatively short distance in the second semiconductor region, to prevent a parasitic transistor formed with the first to third semiconductor regions from being turned on.

As a result, the field effect semiconductor device is effectively prevented from being broken down through the parasitic transistor.

Since the first major electrode layer is in contact with the part of the alternately exposed pattern, the other part of the alternately exposed pattern lies under the insulating layer in which the control electrode is buried. In other words, it is unnecessary to shift the side end edge of the insulating layer back to the ringlike exposed area outside the alternately exposed pattern. The field effect semiconductor device which is prevented from being broken down due to the electrical continuity of the parasitic transistor is provided independently of mask alignment accuracy for the formation of the insulating layer and control electrode.

The method of the present invention provides for the fabrication of the field effect semiconductor devices having the foregoing advantages.

It is an object of the present invention to provide a field effect semiconductor device capable of preventing the breakdown thereof due to electrical continuity of a parasitic transistor, and a method of fabricating the same.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a plan view of one cell of an IGBT according to a preferred embodiment of the present invention;
Fig. 2 is a cross-sectional view taken along the line A0 - A0 of Fig. 1;
Fig. 3 is a cross-sectional view taken along the line B0 - B0 of Fig. 1;
Fig. 4 illustrates an alternately exposed pattern in the IGBT of Fig. 1;
Fig. 5 is a schematic exploded view of a part of the IGBT of Fig. 1;
Fig. 6 illustrates a parasitic transistor in the IGBT of Fig. 1;
Fig. 7 is a cross-sectional view of a first comparable example for the IGBT of the preferred embodiment;
Fig. 8 is a plan view of a second comparable example for the IGBT of the preferred embodiment;
Fig. 9 is a cross-sectional view taken along the line C1 - C1 of Fig. 8;
Fig. 10 is a plan view of one cell of a power MOSFET according to another preferred embodiment of the present invention;
Fig. 11 is a cross-sectional view taken along the line A2 - A2 of Fig. 10;
Figs. 12 to 19 are cross-sectional views showing process steps for fabricating the IGBT of Fig. 1;
Figs. 20 and 21 are cross-sectional views showing process steps for fabricating the power MOSFET of Fig. 10;
Fig. 22 is a plan view of one cell of a conventional power MOSFET;
Fig. 23 is a cross-sectional view taken along the line A3 - A3 of Fig. 23;
Fig. 24 is a cross-sectional view taken along the line B3 - B3 of Fig. 23;
Fig. 25 is a schematic exploded view of a part of the power MOSFET of Fig. 23; and
Fig. 26 illustrates a parasitic transistor in the power MOSFET of Fig. 23.

### DESCRIPTION OF THE PREFERRED EMBODIMENTS

### < Structure of Device >

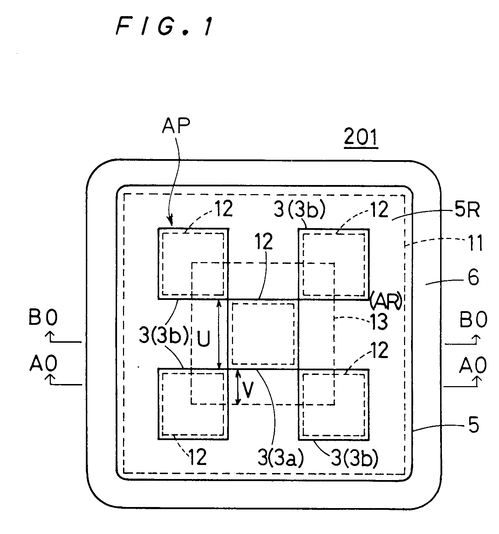

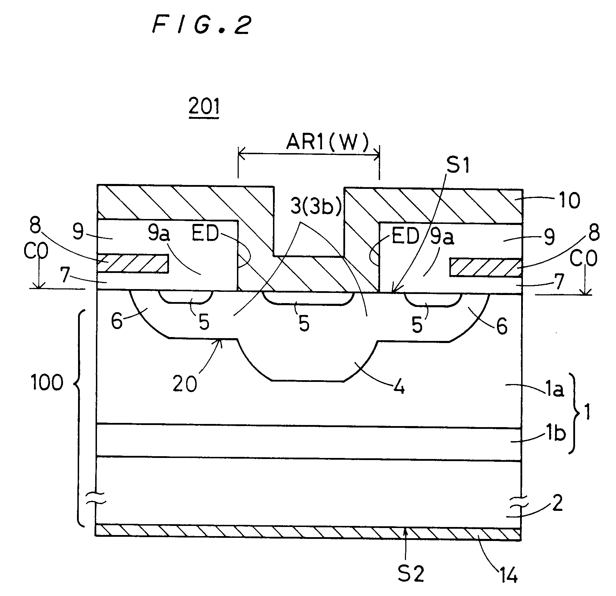

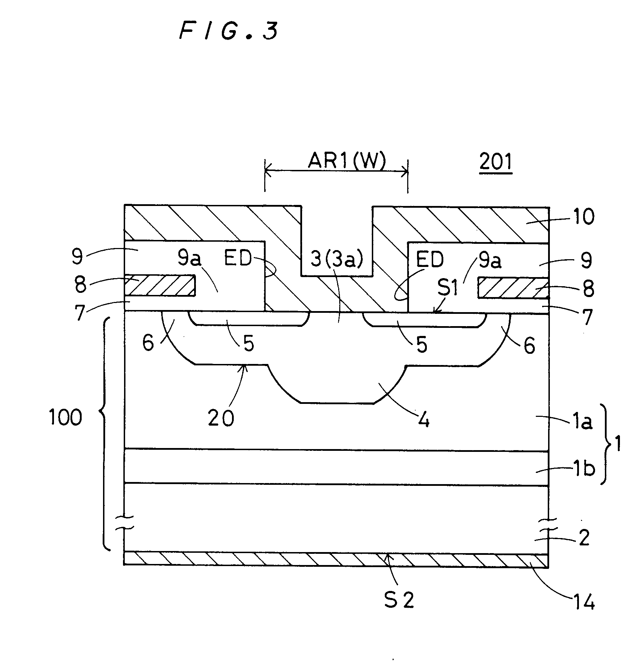

Fig. 1 is a plan view of a unit cell of an N-channel insulated gate bipolar transistor (referred to as an "IGBT" hereinafter) 201 according to a preferred embodiment of the present invention. Figs. 2 and 3 are cross-sectional views taken along the lines A0 - A0 and B0 - B0 of Fig. 1, respectively. Fig. 1 corresponds to a plan view as viewed along the line C0 - C0 of Fig. 2. Although the IGBT 201 includes a multiplicity of unit cells arranged in matrix configuration, the respective unit cells have substantially the same structure. Hence all of the cells are appreciable from Figs. 1 to 3.

With reference to Fig. 2, the IGBT 201 includes a semiconductor body 100 and structures formed on upper and lower major surfaces S1 and S2 of the semiconductor body 100. The lowest in the semiconductor body 100 is a p⁺ drain region 2. An n⁺ drain region 1b and an n⁻ drain region 1a are formed in this order on the p⁺ drain region 2 to form an n drain region 1. A drain electrode 14 in contact with the p⁺ drain region 2 is formed on the lower major surface S2 of the IGBT 201.

A p-type region 20 is selectively formed in an upper surface portion of the n⁻ drain region 1a. The p-type region 20 includes a combination of a p⁺ semiconductor region 4 and a p-type semiconductor region 3. The peripheral portion of the p-type semiconductor region 3 is a rectangular, ringlike channel formation region 6, as shown in Fig. 1.

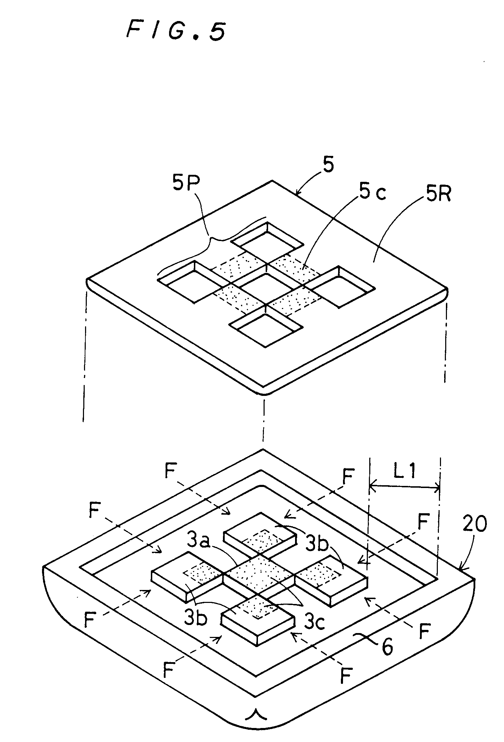

An n⁺ source region 5 is selectively formed in an upper surface portion of the p-type region 20. There is schematically shown in Fig. 5 geometric relation between the p-type region 20 and n⁺ source region 5. Similarly to Fig. 25, the p-type region 20 and n⁺ source region 5 are shown vertically spaced apart from each other in simplified configurations in Fig. 5, for the purpose of simplification.

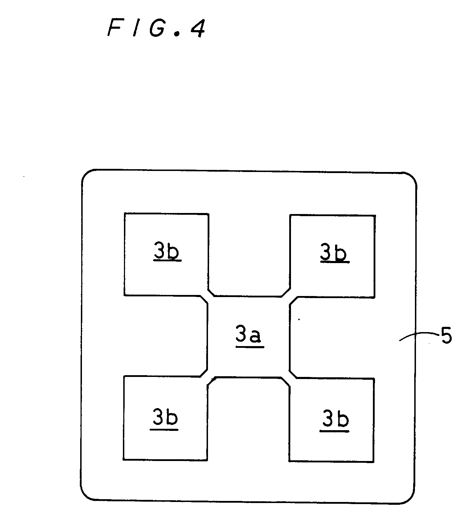

Referring to Fig. 5, the n⁺ source region 5 includes a ring portion 5R of rectangular, ringlike configuration and a pattern portion 5P having a plurality of rectangular through holes inside the ring portion 5R. Rectangular p-type semiconductor regions 3a and 3b corresponding to respective portions of the p-type semiconductor region 3 are exposed through the through holes of the pattern portion 5P. The p-type semiconductor region 3a lies in the center of the p-type region 20. The four p-type semiconductor regions 3b extend diagonally from the vertexes of the p-type semiconductor region 3a toward the respective corners of the n⁺ source region 5. The p-type semiconductor regions 3a and 3b are, exactly, linked to each other at their vertexes, as shown in Fig. 4.

The alternate exposure of the pattern portion 5P of the n⁺ source region 5 with the p-type semiconductor regions 3a, 3b forms an alternately exposed pattern AP on the upper major surface S1 of the semiconductor body 100 as shown in Fig. 1. The alternately exposed pattern AP is a checkered pattern lying inside the ring portion 5R of the n⁺ source region 5.

Referring again to Figs. 2 and 3, a gate oxide film 7 is selectively formed on the upper major surface S1 of the semiconductor body 100. A gate electrode 8 is formed on the gate oxide film 7. A layer insulating film 9 lies on the gate electrode 8. Part of an insulating layer composed of the insulating films 7, 9 which lies on the side face of the gate electrode 8 is a gate side face insulating film 9a, which defines a window W. The bottom of the window W is an area AR on the upper major surface S1. Note that an edge ED of the gate side face insulating film 9a overlies the p-type semiconductor regions 3b in Fig. 2. Advantages of such positional relation will be described later.

There is shown in Fig. 1 a mask pattern 11 used for the formation of the whole p-type semiconductor region 3 with broken lines. In Fig. 1 are also shown mask patterns 12 and 13 used for the formation of the n⁺ source region 5 and for the formation of the insulating films 7 and 9, respectively. The range of the mask pattern 13 is equivalent to the area AR of Fig. 2, which overlaps the central portion of the alternately exposed pattern AP. The p-type semiconductor region 3a is located in the area AR. Each of the p-type semiconductor regions 3b is disposed across the edge of the area AR. The length of the sides of the p-type semiconductor regions 3a, 3b is about one-half of the length of the sides of the area AR.

Referring to Figs. 2 and 3, a source electrode 10 is formed on the top surface of the IGBT 201. Part of the source electrode 10 contacts the p-type semiconductor region 3 and n⁺ source region 5 in the window W of the insulating films 7, 9. This causes the p-type semiconductor region 3 and n⁺ source region 5 to short-circuit each other, and a source potential is applied to the p-type semiconductor region 3 and n⁺ source region 5 from the source electrode 10. Areas 3c and 5c shaded with dots in Fig. 5 are parts of the regions 3 and 5 which are brought into contact with the source electrode 10. The area 5c is to hold an electrical contact between the n⁺ source region 5 and source electrode 10, and it is preferable that a contact width U (of Fig. 1) is not very small. When the width U is small, the sheet resistance of the n⁺ source region 5 increases. On the other hand, a contact length V (of Fig. 1), which is independent of the sheet resistance of the n⁺ source region 5, is preferably relatively small as far as the electrical contact between the n⁺ source region 5 and source electrode 10 is achieved.

### < Operations and Characteristics of Device >

In the IGBT 201, channels are formed in a channel formation region 6 when a drain voltage is applied across the drain and source electrodes 14 and 10 and a gate voltage is applied across the gate and source electrodes 8 and 10. Electrons flow into the p⁺ drain region 2 through the channels and regions 1a, 1b. Holes correspondingly flow from the p⁺ drain region 2 through the regions 1a, 1b into the p-type region 20. These currents allow a drain current to flow across the drain and source electrodes 14 and 10. The magnitude of the drain current is controlled by variations in the magnitude of the gate voltage.

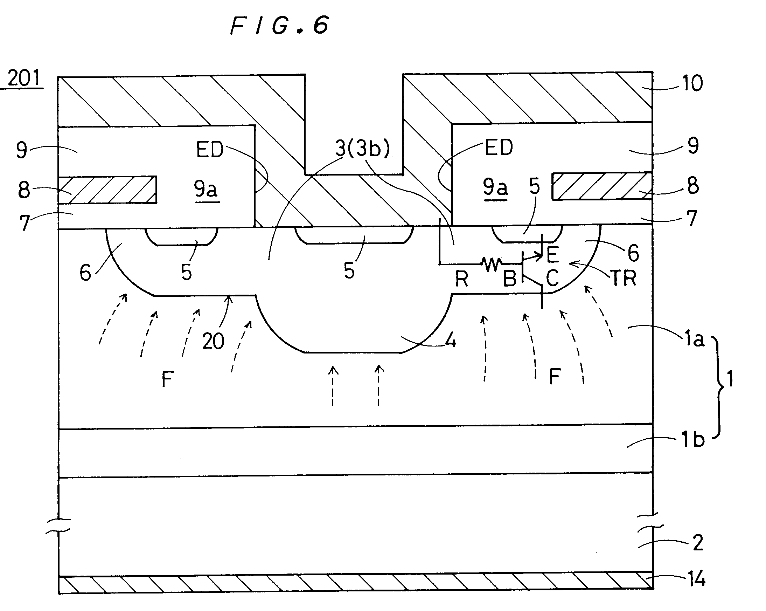

An npn parasitic transistor TR is formed in the IGBT 201 as shown in Fig. 6. Almost all electrons flow from the p-type semiconductor regions 3b into the n⁻ drain region 1a in the ON-state, and holes correspondingly travels from the n⁻ drain region 1a to the p-type region 20. The holes travels in a base B of the parasitic transistor TR.

Hole currents F, after entering the p-type region 20, reach the p-type semiconductor regions 3b by travelling relatively short distances, as indicated by the broken arrows of Fig. 5. Since a distance L1 between the channel formation region 6 and p-type semiconductor regions 3b in the diagonal directions is particularly small, the holes reach the p-type semiconductor regions 3b without travelling long distances in this portion.

This relatively decreases a base resistance R (of Fig. 6) of the parasitic transistor TR, so that a voltage drop is small in the resistance R. Thus the parasitic transistor TR is not easily turned on, preventing the latch-up of the IGBT 201 effectively.

### < Comparison with Other Structures >

The meaning of the detailed structure of the IGBT 201 of the preferred embodiment will be described in detail in comparison with other structures of IGBT.

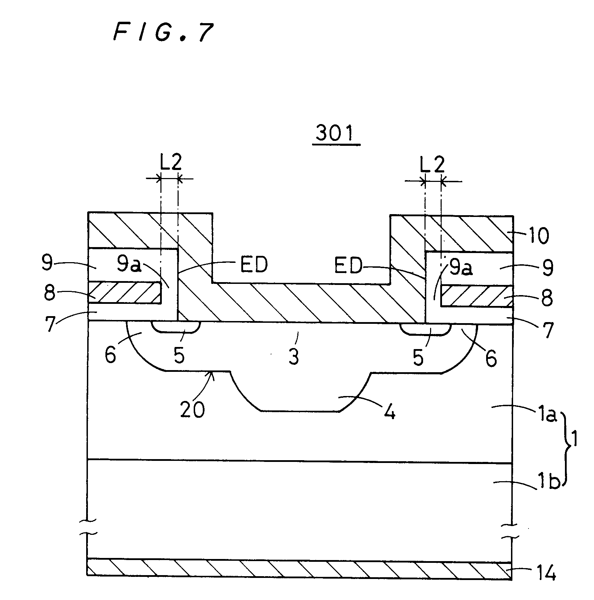

Fig. 7 shows a device 301 having a structure similar to that of Figs. 22 to 26 with a smaller width of the n⁺ source region 5. The width of the p-type semiconductor region 3 under the n⁺ source region 5 is smaller than that of Fig. 24, so that the latch-up preventing effect is expected. However, the lateral thickness of the gate side face insulating film 9a must be reduced in order to dispose the edge ED on the n⁺ source region 5. The lateral thickness of the gate side face insulating film 9a depends on the positioning accuracy of masks used for the patterning of the gate electrode 8 and for the patterning of the gate side face insulating film 9a.

It is, hence, difficult in the device 301 of Fig. 7 to considerably reduce the lateral thickness of the n⁺ source region 5. When it is forced to, the insulation of the gate electrode 8 on the side face deteriorates.

In the device 201 of the preferred embodiment, on the other hand, the edge ED which overlies the p-type semiconductor region 3 need not be shifted toward the gate electrode 8. The structure of the device 201 enables the prevention of the latch-up with the insulation of the gate electrode 8 on the side face ensured with sufficiently large lateral thickness of the n⁺ source region 5.

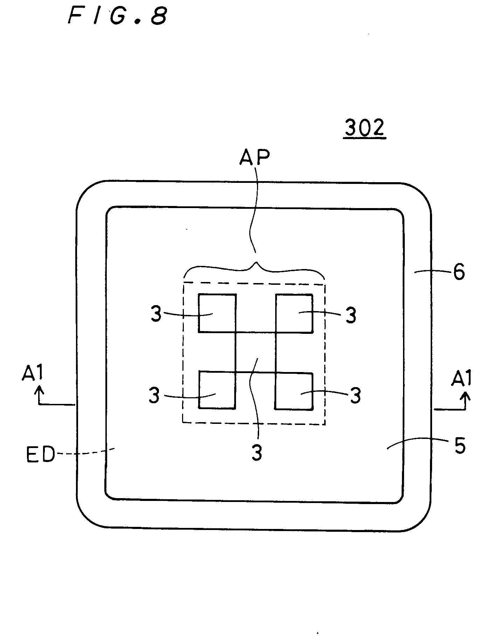

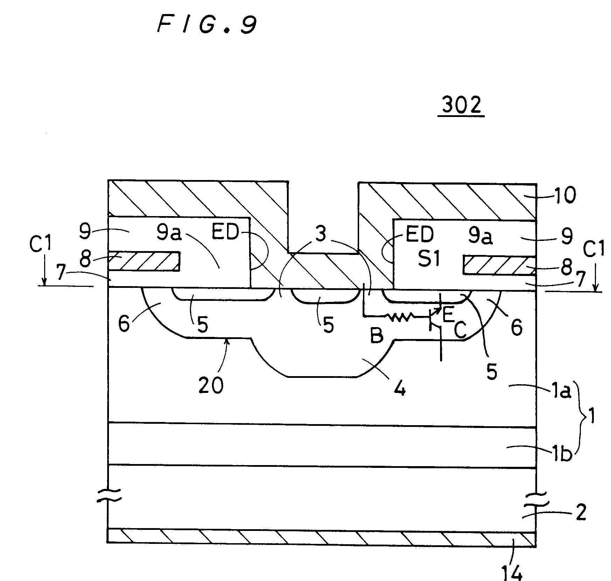

Fig. 8 is a plan view of another device 302 to be compared with the device of the preferred embodiment. Fig. 9 is a cross-sectional view taken along the line A1 - A1 of Fig. 8. Fig. 8 corresponds to a plan view as viewed along the line C1 - C1 of Fig. 9. The device 302 is similar to the device 201 of the preferred embodiment in that the exposed surfaces of the p-type semiconductor region 3 and n⁺ source region 5 are checkered. A structural difference therebetween is that an area corresponding to the bottom of the window of the insulating films 7, 9 covers "all" of the alternately exposed pattern of Fig. 8 in the device 302, but the area covers "part" of the alternately exposed pattern in the device 201. The edge ED, accordingly, is not located on the p-type semiconductor region 3 but on the n⁺ source region 5 in Fig. 8.

It is necessary in the device 302 to increase the lateral length of the n⁺ source region 5 under the gate side face insulating film 9a in order to locate the edge ED on the n⁺ source region 5. This increases the base resistance R (of Fig. 9) of the parasitic transistor and, accordingly, increases the voltage drop in the resistance R. Hence the parasitic transistor is turned on, so that the problem of the generation of the latch-up occurs.

In addition, the electrical contact between the source electrode 10 and n⁺ source region 5 is achieved in Fig. 9 by the two side parts among three parts of the n⁺ source region 5 shown in Fig. 9. The center part of the n⁺ source region 5 of Fig. 9 is unnecessary. The presence of the center part decreases the contact area between the p-type seniconducdtor region 3 and source electrode 10 of Fig. 8.

In the device 201 of the preferred embodiment, on the other hand, the two side parts among three parts of the n⁺ source region 5 shown in Fig. 2 do not directly contact the source electrode 10. This necessitates the center part of the n⁺ source region 5 of Fig. 2 to achieve the electrical contact between the source electrode 10 and n⁺ source region 5. Unlike the device 302 of Figs. 8 and 9, the formation of the alternately exposed pattern AP and the contact of the source electrode 10 with part of the pattern AP in the preferred embodiment are based on the sufficient technical reason.

### < Fabrication Process >

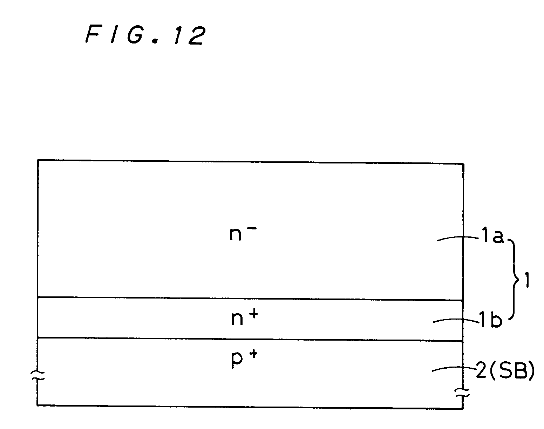

Description will be given hereinafter on a process for fabricating the IGBT 201 of the preferred embodiment with reference to Figs. 12 to 19.

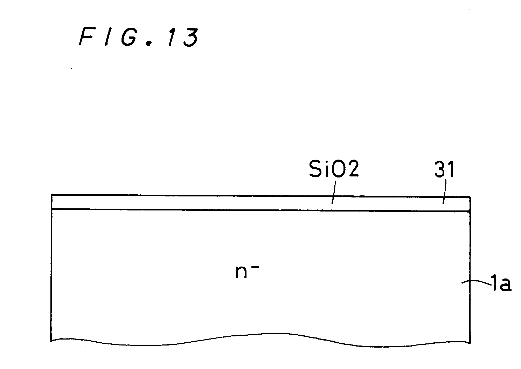

Initially, a p-type silicon substrate SB corresponding to the p⁺ drain region 2 is prepared, as shown in Fig. 12. The n⁺ drain region 1b and n⁻ drain region 1a are formed in this order on the substrate SB by means of the epitaxial growth technique to form the n⁻ drain region 1. Figs. 13 to 18 show only the n⁻ drain region 1a and structure to be formed thereabove.

In the process step of Fig. 13, a silicon oxide film 31 is formed on the n⁻ drain region 1a.

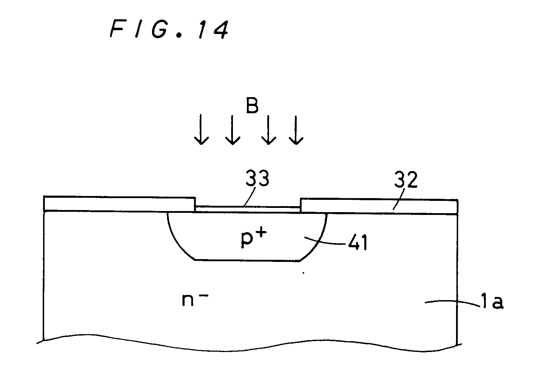

The silicon oxide film 31 is selectively etched away to form an oxide film 32 having a window, as shown in Fig. 14. A thin silicon oxide film 33 is formed in the window. The n⁻ drain region 1a is implanted with boron of relatively high concentration through the silicon oxide film 33. A p⁺ region 41 is formed in a surface portion of the n⁻ drain region 1a by the drive-in process.

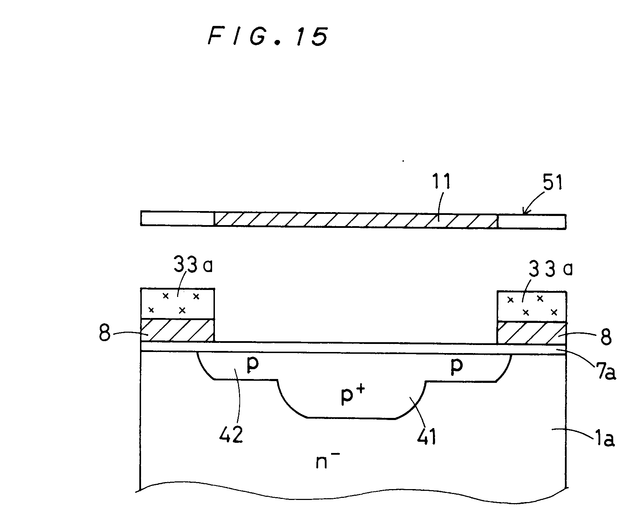

The oxide films 32 and 33 are removed, and a silicon oxide film 7a is formed all over, as shown in Fig. 15. Polysilicon is formed over the oxide film 7a, and a resist layer is formed over the polysilicon. Photolithography process is carried out on the resist layer by using a mask 51 having a pattern corresponding to the mask pattern 11 of Fig. 1, to provide a resist pattern 33a. The polysilicon is selectively etched away, masked with the resist pattern 33a, so that the gate electrode 8 is formed on the oxide film 7a. Masked with the resist pattern 33a and gate electrode 8, the n⁻ drain region 1a is selectively implanted with boron of relatively low concentration to form a p⁺ semiconductor region 42.

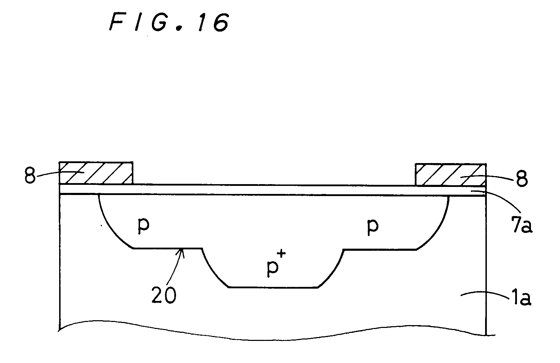

The resist pattern 33a is subsequently removed. The boron in the regions 41, 42 is diffused to a portion under the gate electrode 8 by the drive-in process to provide the p-type region 20 of Fig. 16.

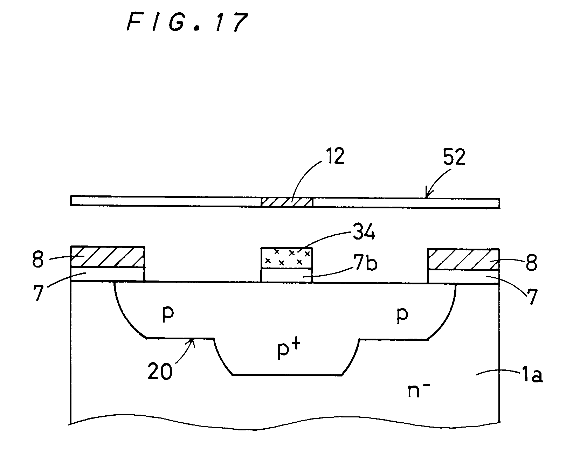

A resist layer is formed all over and is then patterned by the photolithography process using a mask 52 of Fig. 17 to provide a resist pattern 34. A pattern formed in the mask 52 corresponds to the mask pattern 12 of Fig. 1.

Masked with the resist pattern 34 and gate electrode 8, the oxide film 7a of Fig. 16 is selectively etched away to provide oxide film patterns 7, 7b of Fig. 17. The oxide film pattern 7 corresponds to the gate oxide film 7 of Fig. 1.

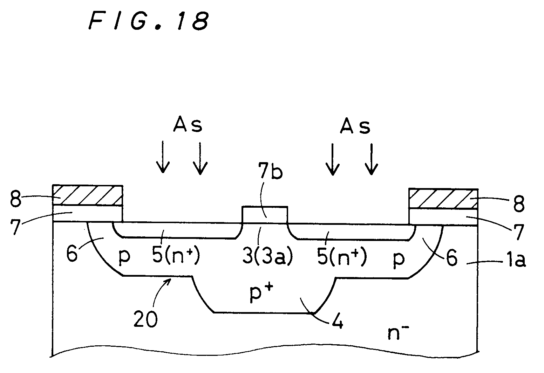

After the removal of the resist pattern 34, arsenic is selectively implanted into the surface portion of the p-type region 20 using the oxide film pattern 7b and gate electrode 8 as a mask, as shown in Fig. 18. This provides the pattern of the n⁺ source region 5 in the surface portion of the p-type region 20.

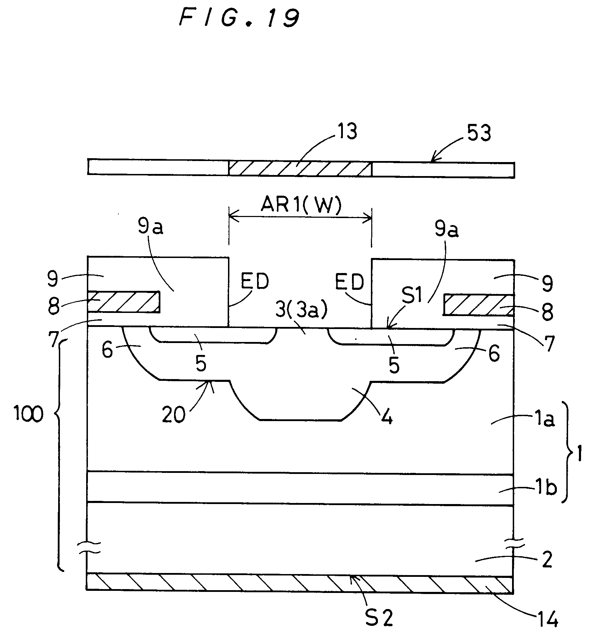

A relatively thick silicon oxide film is provided all over, and is then selectively etched away by using a mask 53 of Fig. 19. A pattern formed in the mask 53 corresponds to the mask pattern 13 of Fig. 1. This provides the silicon oxide films 9, 9a having the window W. The silicon oxide film 9 corresponds to the layer insulating film 9 of Fig. 1, and the silicon oxide film 9a corresponds to the gate side face insulating film 9a of Fig. 1. The edge ED of the side face insulating film 9a lies on the n⁺ source region 5 in Fig. 19, but it lies on the p-type semiconductor region 3 as viewed in cross section corresponding to Fig. 2.

An aluminium film is formed over the structure thus obtained to form the source electrode 10 of Fig. 1. Part of the source electrode 10 which is in the window W short-circuits the p-type semiconductor region 3 and n⁺ source region 5.

A metalized layer is formed over the lower major surface S2 of the semiconductor body 100 to form the drain electrode 14.

### < Other Preferred Embodiments >

The present invention is applicable not only to the N-channel IGBTs but also to P-channel IGBTs and field effect semiconductor devices other than the IGBT.

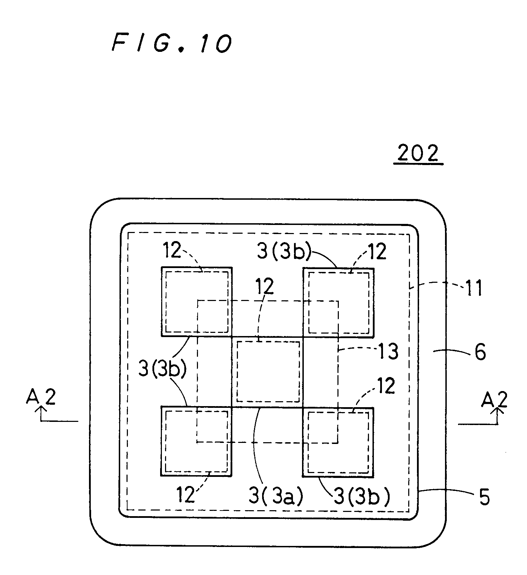

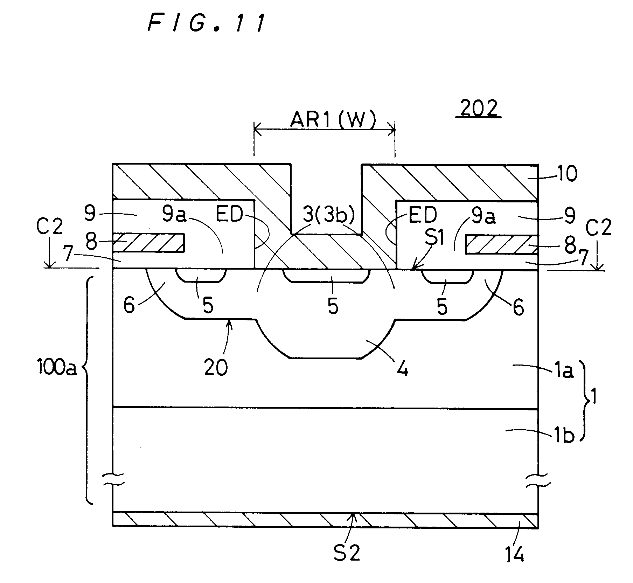

Fig. 10 is an application of the present invention to a power MOSFET, and corresponds to Fig. 1 for the IGBT 201. Fig. 11 is a cross-sectional view taken along the line A2 - A2 of Fig. 10. Fig. 10 corresponds to a plan view as viewed along the line C2 - C2 of Fig. 11.

This type of power MOSFET 202 has a structure similar to the IGBT 201 of Figs. 1 to 6 except that the power MOSFET 202 does not include the p⁺ drain region 2 of Fig. 2 and that the n⁺ drain region 1b is exposed on the lower major surface S2 of a semiconductor body 100a and contacts the drain electrode 14.

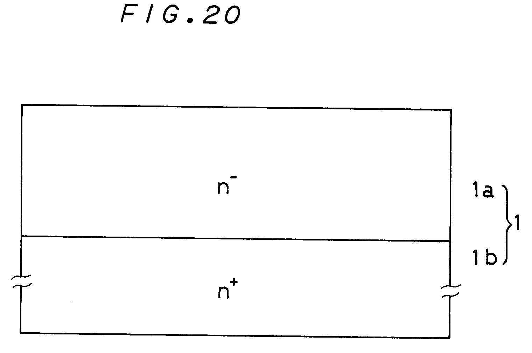

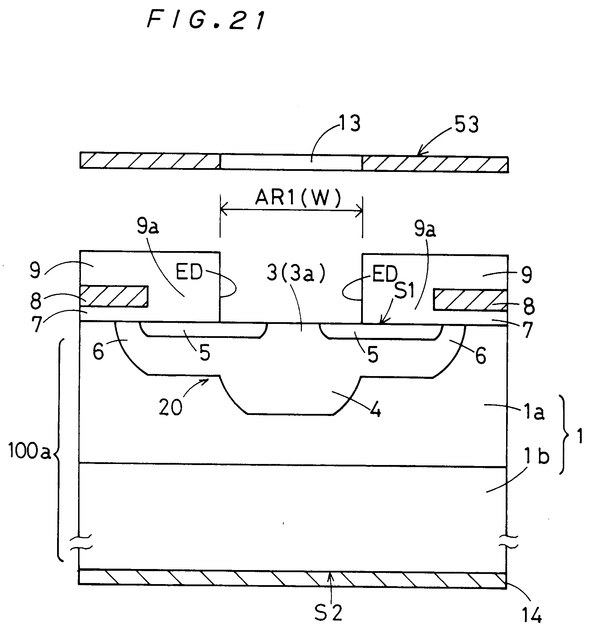

The power MOSFET 202 is fabricated by a process similar to that of the IGBT 201 of the preferred embodiment except that a substrate having the n⁺ drain region 1b on the lower surface side as shown in Fig. 20 is substituted for the structure of Fig. 12 and that the drain electrode 14 is formed to come into contact with the n⁺ drain region 1b as shown in Fig. 21.

The n⁺ source region 5 of Figs. 1 to 6, 10 and 11 should be exposed inside the ringlike area 5R in alternate relation to the p-type semiconductor region 3, and is not limited to the checkered pattern. The n⁺ source region 5 and p-type semiconductor region 3 may be exposed alternately in plane configurations such as polka dots. The checkered pattern, however, is fabricated without difficulty, and provides the required effects with the simplest pattern.

While the invention has been shown and described in detail, the foregoing description is in all aspects illustrative and not restrictive. It is therefore understood that numerous modifications and variations can be devised without departing from the scope of the invention.

## Claims

1. A field effect semiconductor device comprising:
(a) a semiconductor body including:
(a-1) a first semiconductor region of a first conductivity type exposed on an upper major surface of said semiconductor body;
(a-2) a second semiconductor region of a second conductivity type selectively formed in an upper surface portion of said first semiconductor region and selectively exposed on said upper major surface of said semiconductor body; and
(a-3) a third semiconductor region of the first conductivity type selectively formed in an upper surface portion of said second semiconductor region and exposed in a ringlike exposed area inside a peripheral portion of the exposed surface of said second semiconductor region, said third semiconductor region being exposed alternately with said second semiconductor region inside said ringlike exposed area to form an alternately exposed pattern on said upper major surface of said semiconductor body;
(b) an insulating layer selectively formed on said upper major surface of said semiconductor body and having a window on a first area partially covering said alternately exposed pattern;
(c) a control electrode layer buried in said insulating layer and opposed to said peripheral portion of the exposed surface of said second semiconductor region;
(d) a first major electrode layer formed in said window and contacting said alternately exposed pattern in said first area; and
(e) a second major electrode layer formed on a lower major surface of said semiconductor body.

2. The field effect semiconductor device of claim 1, wherein said second semiconductor region includes:
(a-2-1) a first portion selectively exposed in a center portion of said first area; and
(a-2-2) a plurality of second portions selectively exposed across an edge of said first area.

3. The field effect semiconductor device of claim 2,
wherein said second semiconductor region is selectively exposed on said upper major surface of said semiconductor body inside a second area of substantially rectangular configuration enclosing said first area, and
wherein said plurality of second portions of said second semiconductor region are exposed respectively in a plurality of third areas ex:ending from said first portion toward respective corners of said second area on said upper major surface of said semiconductor body.

4. The field effect semiconductor device of claim 3, wherein respective exposed areas of said first portion and said plurality of second portions of said second semiconductor region form a checkered pattern exposed on said upper major surface of said semiconductor body and wherein said checkered pattern serves as said alternatively exposed pattern.

5. The field effect semiconductor device of claim 4,
wherein said first portion of said second semiconductor region is exposed on said upper major surface of said semiconductor body in a first unit rectangular area lying in the center of said checkered pattern, and
wherein said plurality of second portions of said second semiconductor region extend from said first unit rectangular area toward the respective corners of said second area and are exposed on said upper major surface of said semiconductor body in a plurality of second unit rectangular areas serving as said plurality of third areas.

6. The field effect semiconductor device of claim 5,
wherein said first area is of substantially rectangular plane configuration; and
wherein respective sides of said first unit rectangular area are substantially half as long as respective sides of said first area.

7. The field effect semiconductor device of claim 6, further comprising
(f) a fourth semiconductor region of the second conductivity type formed between said lower major surface of said semiconductor body and said first semiconductor region.

8. A method of fabricating a field effect semiconductor device, comprising the steps of:
(a) providing a semiconductor body including a first semiconductor region of a first conductivity type, said first semiconductor region being exposed on an upper major surface of said semiconductor body;
(b) selectively introducing impurities of a second conductivity type into said upper major surface of said semiconductor body to selectively form a second semiconductor region of the second conductivity type in an upper surface portion of said first semiconductor region, said second semiconductor region being selectively exposed on said upper major surface of said semiconductor body;
(c) forming an oxide film on said upper major surface of said semiconductor body;
(d) forming on said oxide film a control electrode layer having a first window on an area enclosing a part of said oxide film which is opposed to said second semiconductor region;
(e) selectively further introducing impurities of the second conductivity type into said upper major surface of said semiconductor body through said first window;
(f) selectively diffusing said impurities of the second conductivity type introduced in said step (e) into said first semiconductor region to expand said second semiconductor region up to a part of said semiconductor body which lies under said control electrode layer;
(g) selectively removing a part of said oxide film which lies under said first window to provide a combination of a first insulating film and an insulating pattern, said first insulating film lying under said control electrode layer, said insulating pattern selectively lying in said first window;
(h) selectively introducing impurities of the first conductivity type into the exposed surface of said second semiconductor region except an peripheral port ion thereof while using said insulating pattern as a mask, to selectively form a third semiconductor region of the first conductivity type in an upper surface portion of said second semiconductor region, said third semiconductor region being exposed alternately with said second semiconductor region inside said area to form an alternately exposed pattern on said upper major surface of said semiconductor body;
(i) removing said insulating pattern;
(j) forming a second insulating film covering side and upper surfaces of said control electrode layer and having a second window opposed to a part of said alternately exposed pattern;
(k) forming a first major electrode layer in said second window; and
(l) forming a second major electrode layer on a lower major surface of said semiconductor body.

9. The method of claim 8, wherein said step (b) includes the steps of:
(b-1) forming a first oxide film on said upper major surface of said semiconductor body;
(b-2) selectively removing said first oxide film to form a third window;
(b-3) forming a second oxide film in said third window, said second oxide film being thinner than said first oxide film;
(b-4) introducing said impurities of the second conductivity type into said upper surface portion of said first semiconductor region through said second oxide film; and
(b-5) removing said first and second oxide films.

10. The method of claim 9, wherein said step (g) includes the steps of:
(g-1) obtaining a first mask having a checkered pattern; and
(g-2) selectively removing said oxide film using said first mask.

11. The method of claim 10, wherein said first mask has a first unit rectangular pattern lying centrally and a plurality of second unit rectangular patterns extending in diagonal directions of said first unit rectangular pattern.

12. The method of claim 11, wherein said step (j) includes the steps of:
(j-1) forming a third oxide film on an upper major surface of a structure obtained in the step (i);
(j-2) obtaining a second mask having a substantially rectangular pattern covering all of said first unit rectangular pattern and part of each of said plurality of second unit rectangular patterns; and
(j-3) selectively removing said third oxide film using said second mask to provide said second insulating film.

13. The method of claim 12, wherein said step (j-2) includes the step of
(j-2-1) providing said second mask such that the length of respective sides of said first unit rectangular pattern and said plurality of second unit rectangular patterns is approximately one-half of the width of said substantially rectangular pattern of said second mask.

14. A feild effect semiconductor device substantially as described with reference to figures 1 to 9 or figures 10 and 11 of the accompanying drawings.

15. A method of making a field effect semiconductor device, substantially as herein described with reference to figures 12 to 19 or figures 20 and 21 of the accompanying drawings.
